# EUROPEAN PATENT APPLICATION

(11) **EP 0 531 914 A2**
(43) Date of publication of application: **17.03.1993**
(21) Application number: 92115236.9
(22) Date of filing: 05.09.1992
(51) Int. Cl.: H03H 2/00, H01F 10/24, H01F 10/28

(54) **Magnetic thin film for magnetostatic-wave devices**

(30) Priority: 10.09.1991 JP 259629/91; 10.09.1991 JP 259630/91
(71) Applicant: MURATA MANUFACTURING CO., LTD., Nagaokakyo-shi,Kyoto (JP)
(72) Inventor: Fujino, Masaru, Takatsuki-shi, Osaka-fu (JP); Takagi, Hiroshi, Ohtsu-shi, Shiga-ken (JP)
(74) Representative: von Kreisler, Alek, Dipl.-Chem.

(57) **Abstract**

A ferrimagnetic garnet film for magnetostatic wave devices comprises an yttrium-iron-garnet and contains at least one element selected from the group consisting of Bi, Gd, Lu, Sc, La, Ga and Al. The film is epitaxially grown on a nonmagnetic substrate consisting essentially of an unmodified or modified gadolinium-gallium-garnet so that the difference in lattice constant between said film and substrate is not more than 0.001 Å.

## Description

### BACKGROUND OF THE INVENTION

### 1. Field of the Invention

The present invention relates to a magnetic thin film for magnetostatic-wave devices and, more particularly, a ferrimagnetic garnet film epitaxially grown on a non-magnetic substrate for production of magnetostatic wave devices.

### 2. Description of the Prior Art

Recently, magnetostatic wave devices have been reported in various papers, for example, by J.D. Adam, M.R. Daniel and D.K. Schroder "Magnetostatic-wave devices move microwave design into gigaherts realm", Electronics, May, 1980, pp. 123-128, and by T. Nishikawa, K. Wakino, H. Taraha, T.Okada, S. Shinmura and Y. Ishikawa "a low loss magnetostatic wave filter using parallel strip transducers", Microwave and RF Engineering, September/October 1989, pp.63-68.

Such magnetostatic wave devices are generally comprised of a nonmagnetic substrate usually of gadolinium-gallium-garnet (GGG), Gd₃Ga₅O₁₂, and a ferrimagnetic garnet film epitaxially grown thereon. In general, the ferrimagnetic garnet films are made of an yttrium-iron-garnet (YIG), Y₃Fe₅O₁₂, since the epitaxially grown YIG film makes it possible to minimize the difference between input and output signals of the magnetostatic wave devices because of its very narrow magnetic resonance half linewidth (ΔH).

However, the YIG films have such a disadvantage that a temperature coefficient of saturation magnetization (4πMₛ) is large and is fixed to about 2100 ppm/°C. Thus, in order to produce magnetostatic-wave devices with desired temperature characteristics, it is required to choose a permanent magnet with a suitable temperature coefficient of magnetic field. It is, however, difficult to control the temperature characteristics of the magnetostatic wave devices to be produced because of limited kinds of the permanent magnets.

### SUMMARY OF THE INVENTION

It is an object of the present invention to provide a magnetic thin film for magnetostatic-wave devices of which a temperature coefficient of saturation magnetization (4πMₛ) is capable of being controlled within a wide range, without increasing its narrow magnetic resonance half linewidth (ΔH).

According to the present invention there is provided a ferrimagnetic garnet film for magnetostatic wave devices, said film comprising an yttrium-iron-garnet and containing at least one element selected from the group consisting of Bi, Gd, Lu, Sc, La, Ga and Al, said ferrimagnetic garnet film being epitaxially grown on a nonmagnetic substrate consisting essentially of an unmodified or modified gadolinium-gallium-garnet so that the difference in lattice constant between said film and substrate is not more than 0.001 Å.

As a material for nonmagnetic substrates, there may be used those consisting essentially of an unmodified or modified gadolinium-gallium-garnet. It is, however, to use a modified gadolinium-gallium-garnet having a composition expressed by the general formula:

Gd₃₋ₘRₘGa₅₋ₙAlₙO₁₂

wherein R is at least one rare earth element other than Gd, 0 ≦ m ≦ 1.00, and 0 ≦ n < 5.

If m = 0 and n = 0, a composition is an unmodified gadolinium-gallium-garnet.

As mentioned above, the ferrimagnetic garnet film of the present invention consists essentially of a yttrium-iron-garnet and containing at least one element selected from the group consisting of Bi, Gd, Lu, Sc, La, Ga and Al. Thus, it is presumed from size considerations that elements, Bi, Gd, Lu, Sc and La enter the Y position while the other element, Ga and Al, enter the Fe position. From such a standpoint, the ferrimagnetic garnet films of the present invention may have a composition expressed by the general formula (I):

Y₃₋ₓMₓFe_{5-y}M'_{y}O₁₂

where M is at least one element selected from the group consisting of Bi, Gd, Lu, Sc and La, M' is at least one element selected from the group consisting of Ga and Al, x and y take a value in the respective following ranges: 0 ≦ x ≦ 1.00 and 0 ≦ y ≦ 1.00, excepting x = y = 0.

If y = 0 in the general formula (I), the above ferrimagnetic garnet film may have a composition expressed by the general formula (II):

Y₃₋ₓMₓFe₅O₁₂

where M is at least one element selected from the group consisting of Bi, Gd, Lu, Sc and La, and 0 < x ≦ 1.00.

If x = 0 in the general formula (I), the above ferrimagnetic garnet film may have a composition expressed by the general formula (III):

Y₃Fe_{5-y}M'_{y}O₁₂

where M' is at least one element selected from the group consisting of Ga and Al, and 0 < y ≦ 1.00.

According to the present invention, there is provided a ferrimagnetic garnet film for magnetostatic wave devices, said film comprising a modified yttrium-iron-garnet having a composition expressed by the general formula:

Y₃₋ₓMₓFe_{5-y}M'_{y}O₁₂

where M is at least one element selected from the group consisting of Bi, Gd, Lu, Sc and La, M' is at least one element selected from the group consisting of Ga and Al, x and y take a value in the respective following ranges: 0 ≦ x ≦ 1.00, and 0 ≦ y ≦ 1.00, excepting x = y = 0, said film being epitaxially grown on a nonmagnetic substrate consisting essentially of an unmodified or modified gadolinium-gallium-garnet so that the difference in lattice constant between said film and substrate is not more than 0.001 Å, said unmodified or modified gadolinium-gallium-garnet having a composition expressed by the general formula:

Gd₃₋ₘRₘGa₅₋ₙAlₙO₁₂

where R is at least one rare earth element other than Gd, 0 ≦ m ≦ 1.00, and 0 ≦ n < 5. However, a composition with m = 0 and n = 0 is excluded from the scope of the present invention.

The ferrimagnetic garnet film of the present invention is formed on the modified gadolinium-gallium-garnet substrate so that the difference in lattice constant between the film and substrate is not more than 0.001 Å. This makes it possible to produce a ferrimagnetic thin films with any desired temperature coefficient of saturation magnetization in the range of from about 1500 to about 2150 ppm/°C, without increasing the magnetic resonance half linewidth (ΔH). According to the present invention, it is also possible to improve the temperature characteristics of magnetostatic wave devices by the suitable choice of the permanent magnet to be used.

The above and other objects, features and advantages of the present invention will be understood clearly from the following explanations with reference to several examples.

### Example 1

By the Czochralski method, there were prepared single crystals of unmodified or modified gadolinium-gallium-garnet having a composition shown in Table 1. The resultant single crystals were respectively sliced and polished to prepare substrates.

Ferrimagnetic garnet films having a composition shown in Table 1 were prepared on the resultant substrates by the liquid-phase epitaxy (LPE) in the following manner.

Powders of Fe₂O₃, Y₂O₃, oxides of additives were weighed and mixed so as to have a composition shown in Table 1. The resultant mixture was added with a suitable amount of a solvent composed of PbO and B₂O₃_{,} put into a platinum crucible in a vertical electric furnace, and then heated to 1200 °C to prepare a homogeneous melt.

The melt was then cooled to about 900 °C and maintained at that temperature to make the garnet into a supersaturated state. Then, the above substrate was immersed in the melt and rotated therein for a certain period of time to allow garnet crystals to grow on the substrate. The substrate was then drawn up from the melt and rotated at a high rate of revolution to remove the melt from the surface of the garnet film epitaxially grown on the substrate.

The resultant garnet films were subjected to measurements of the lattice constant, saturation magnetization (4πMₛ), temperature coefficient (TC) of 4πMₛ, and magnetic resonance half linewidth (ΔH). The lattice constant was determined by the X-ray diffraction, while the saturation magnetization (4πMₛ) and the magnetic resonance half linewidth (ΔH) were measured with an electron spin resonance (ESR) spectroscopy. Results are shown in Table 2.

In the table, the specimens with an asterisk (*) are those out of the scope of the present invention.

**Table 1**

| No. | Composition of substrate | Composition of garnet film |
|---|---|---|
| 1* | Gd₂SmGa₅O12 | Y_{2.5}Bi_{0.5}Fe_{4.5}Ga_{0.5}O₁₂ |
| 2 | Gd₂SmGa₅O₁₂ | Y_{2.4}Bi_{0.6}Fe_{4.5}Ga_{0.5}O₁₂ |
| 3* | Gd₂SmGa₅O₁₂ | Y_{2.3}Bi_{0.7}Fe_{4.5}Ga_{0.5}O₁₂ |
| 4* | Gd_{2.5}Y_{0.5}Ga₅O₁₂ | Y₃Fe_{4.5}Ga_{0.5}O₁₂ |
| 5 | Gd_{2.5}Y_{0.5}Ga₅O₁₂ | Y_{2.9}Bi_{0.1}Fe_{4.5}Ga_{0.5}O₁₂ |
| 6* | Gd_{2.5}Y_{0.5}Ga₅O₁₂ | Y_{2.8}Bi_{0.2}Fe_{4.5}Ga_{0.5}O₁₂ |
| 7 | Gd_{2.8}Ho_{0.2}Ga₅O₁₂ | Y_{2.8}Bi_{0.2}Fe₅O₁₂ |
| 8 | Gd_{2.8}Yb_{0.2}Ga₅O₁₂ | Y_{2.8}Gd_{0.2}Fe₅O₁₂ |
| 9 | Gd_{2.5}Er_{0.5}Ga₅O₁₂ | Y_{2.8}Lu_{0.2}Fe₅O₁₂ |
| 10 | Gd₂YGa₅O₁₂ | Y_{2.8}Sc_{0.2}Fe₅O₁₂ |
| 11 | Gd_{2.8}Ho_{0.2}Ga₅O₁₂ | Y_{2.8}La_{0.2}Fe₅O₁₂ |
| 12 | Gd_{2.5}Er_{0.5}Ga₅O₁₂ | Y₃Fe_{4.8}Ga_{0.2}O₁₂ |
| 13 | Gd₂YGa₅O₁₂ | Y₃Fe_{4.8}Al_{0.2}O₁₂ |
| 14 | Gd₃Ga₅O₁₂ | Y_{2.8}Sm_{0.2}Fe₅O₁₂ |

**Table 2**

| No. | Lattice constant (Å) | | 4πMₛ (G) | ΔH (Oe) | TC of 4πMₛ (ppm/°C) |
|---|---|---|---|---|---|
| | Substrate | Garnet film | | | |
| 1* | 12.416 | 12.408 | 720 | 3.3 | 1720 |
| 2 | 12.416 | 12.415 | 650 | 0.8 | 1500 |
| 3* | 12.416 | 12.423 | 500 | 2.8 | 1430 |
| 4* | 12.374 | 12.369 | 1200 | 2.9 | 2230 |
| 5 | 12.374 | 12.375 | 1060 | 0.6 | 2060 |
| 6* | 12.374 | 12.380 | 1000 | 2.7 | 1940 |
| 7 | 12.387 | 12.386 | 1750 | 0.7 | 2100 |
| 8 | 12.380 | 12.381 | 1620 | 0.9 | 1500 |
| 9 | 12.372 | 12.371 | 1710 | 0.6 | 2000 |
| 10 | 12.361 | 12.360 | 1730 | 0.6 | 2050 |
| 11 | 12.387 | 12.388 | 1540 | 0.8 | 1800 |
| 12 | 12.372 | 12.373 | 1500 | 0.8 | 2000 |
| 13 | 12.361 | 12.361 | 1130 | 0.9 | 1700 |
| 14* | 12.383 | 12.384 | 1600 | 3.9 | 1600 |

As can be seen from the data for specimens No. 1, 3, 4 and 6, if the difference in lattice constant between the film and substrate exceeds 0.001 Å, the magnetic resonance half linewidth (ΔH) becomes considerably large.

As can be seen from the data for specimen No. 14, if a Sm-modified YIG is combined with the unmodified GGG substrate, the magnetic film possesses a wide magnetic resonance half linewidth (ΔH) of 3.9 Oe even if the difference in lattice constant between the film and substrate is not more than 0.001 (Å).

In contrast therewith, from the data for specimens No. 2, 5, 7-13, it will be seen that the present invention makes it possible to produce ferrimagnetic thin films with a temperature coefficient of saturation magnetization ranging from 1500 to 2100 ppm/°C and a narrow magnetic resonance half linewidth (ΔH) of not more than 1.0 Oe.

### Example 2

There were prepared single crystals of modified and unmodified gadolinium-gallium-garnets expressed by the general formula: Gd₃₋ₘRₘGa₅₋ₙAlₙO₁₂, by the Czochralski method so as to have a composition shown in Table 3. Each resultant single crystal was sliced and polished to prepare substrates.

Ferrimagnetic garnet films having a composition shown in Table 3 were deposited on the resultant substrates by the liquid-phase epitaxy (LPE) in the following manner.

Powders of Fe₂O₃, Y₂O₃, oxides of additives were weighed and mixed so as to have a composition shown in Table 1. The resultant mixture was added with a suitable amount of a solvent composed of PbO and B₂O₃_{,} put into a platinum crucible in a vertical electric furnace, and then heated to 1200 °C to prepare a homogeneous melt.

The melt was then cooled to about 900 °C and maintained at that temperature to make the garnet into a supersaturated state. Then, the above substrate was immersed in the melt and rotated therein for a certain period of time to allow garnet crystals to grow on the substrate. The substrate was then drawn up from the melt and rotated at a high rate of revolution to remove the melt from the surface of the garnet film epitaxially grown on the substrate.

For each garnet film, the lattice constant, saturation magnetization (4πMₛ), temperature coefficient (TC) of 4πMₛ, and magnetic resonance half linewidth (ΔH) were measured in the same manner as Example 1. Results are shown in Table 4. In the table, the specimens with an asterisk (*) are those out of the scope of the present invention.

**Table 3**

| No. | Composition of substrate | Composition of ferrimagnetic garnet film |
|---|---|---|
| 15* | Gd₂NdGa_{4.5}Al_{0.5}O₁₂ | Y_{2.4}Bi_{0.6}Fe₄GaO₁₂ |
| 16 | Gd₂NdGa_{4.5}Al_{0.5}O₁₂ | Y_{2.5}Bi_{0.5}Fe₄GaO₁₂ |
| 17* | Gd₂NdGa_{4.5}Al_{0.5}O₁₂ | Y_{2.6}Bi_{0.4}Fe₄GaO₁₂ |
| 18* | Gd_{2.5}Sm_{0.5}Ga_{4.5}Al_{0.5}O₁₂ | Y_{2.9}Bi_{0.1}Fe_{4.3}Ga_{0.7}O₁₂ |
| 19 | Gd_{2.5}Sm_{0.5}Ga_{4.5}Al_{0.5}O₁₂ | Y_{2.8}Bi_{0.2}Fe_{4.3}Ga_{0.7}O₁₂ |
| 20* | Gd_{2.5}Sm_{0.5}Ga_{4.5}Al_{0.5}O₁₂ | Y_{2.7}Bi_{0.3}Fe_{4.3}Ga_{0.7}O₁₂ |
| 21 | Gd_{2.6}Ho_{0.4}Ga_{4.9}Al_{0.1}O₁₂ | Y_{2.8}Bi_{0.2}Fe₅O₁₂ |
| 22 | Gd_{2.8}Ho_{0.2}Ga_{4.9}Al_{0.1}O₁₂ | Y_{2.8}Gd_{0.2}Fe₅O₁₂ |
| 23 | Gd₃Ga_{4.75}Al_{0.25}O₁₂ | Y_{2.8}Lu_{0.2}Fe₅O₁₂ |
| 24 | Gd₃Ga_{4.5}Al_{0.5}O₁₂ | Y_{2.8}Sc_{0.2}Fe₅O₁₂ |
| 25 | Gd_{2.6}Ho_{0.4}Ga_{4.9}Al_{0.1}O₁₂ | Y_{2.8}La_{0.2}Fe₅O₁₂ |
| 26 | Gd₃Ga_{4.75}Al_{0.25}O₁₂ | Y₃Fe_{4.8}Ga_{0.2}O₁₂ |
| 27 | Gd₃Ga_{4.5}Al_{0.5}O₁₂ | Y₃Fe_{4.8}Al_{0.2}O₁₂ |
| 28* | Gd_{2.6}Ho_{0.4}Ga_{4.95}Al_{0.05}O₁₂ | Y_{2.8}Sm_{0.2}Fe₅O₁₂ |

**Table 4**

| No. | Lattice constant (Å) | | 4πMₛ (G) | ΔH (Oe) | TC of 4πMₛ (ppm/°C) |
|---|---|---|---|---|---|
| | Substrate | Garnet film | | | |
| 15* | 12.396 | 12.390 | 930 | 2.9 | 1820 |
| 16 | 12.396 | 12.397 | 820 | 0.9 | 1750 |
| 17* | 12.396 | 12.402 | 700 | 2.7 | 1600 |
| 18* | 12.378 | 12.369 | 1430 | 3.4 | 2190 |
| 19 | 12.378 | 12.378 | 1320 | 0.7 | 2130 |
| 20* | 12.378 | 12.384 | 1200 | 2.9 | 1980 |
| 21 | 12.387 | 12.386 | 1750 | 0.7 | 2100 |
| 22 | 12.382 | 12.381 | 1620 | 0.9 | 1500 |
| 23 | 12.372 | 12.371 | 1710 | 0.6 | 2000 |
| 24 | 12.360 | 12.360 | 1730 | 0.6 | 2050 |
| 25 | 12.387 | 12.388 | 1540 | 0.8 | 1800 |
| 26 | 12.372 | 12.373 | 1500 | 0.8 | 2000 |
| 27 | 12.360 | 12.361 | 1130 | 0.9 | 1700 |
| 28* | 12.384 | 12.384 | 1600 | 3.9 | 1600 |

As can be seen from the data shown in Table 4, the ferrimagnetic thin film of the present invention possesses a narrow magnetic resonance half linewidth (ΔH) of not more than 1.0 Oe, and makes it possible to obtain a desired temperature coefficient of saturation magnetization ranging from 1500 to 2130 ppm/°C.

As can be seen from the data for specimen No. 28, if a Sm-modified YIG is combined with a Ho- and Al-modified GGG substrate in which 0.05 mole of Ga is replaced with the equimolecular amount of Al, the magnetic film possesses a magnetic resonance half linewidth (ΔH) of 3.9 Oe even if the difference in lattice constant between the film and substrate is not more than 0.001 (Å). In contrast therewith, specimens No. 7 and 8 employing the Ho- and Al-modified GGG substrate, in which 0.10 mole of Ga is replaced with the equimolecular amount of Al, possess a magnetic resonance half linewidth (ΔH) of 0.9 Oe.

Thus, it is preferred to use Al-modified GGG substrate with the amount of Al substitution of more than 0.05 mole when gadolinium in the GGG is partially replaced with one or more rare earth elements other than Gd.

## Claims

1. A ferrimagnetic garnet film for magnetostatic wave devices, comprising an yttrium-iron-garnet and containing at least one element selected from the group consisting of Bi, Gd, Lu, Sc, La, Ga and Al, said ferrimagnetic garnet film being epitaxially grown on a nonmagnetic substrate consisting essentially of an unmodified or modified gadolinium-gallium-garnet so that the difference in lattice constant between said film and substrate is not more than 0.001 Å.

2. The ferrimagnetic garnet film for magnetostatic wave devices according to claim 1 wherein said nonmagnetic substrate consists essentially of a modified gadolinium-gallium-garnet having a composition expressed by the general formula:
Gd₃₋ₘRₘGa₅₋ₙAlₙO₁₂
wherein R is at least one rare earth element other than Gd, 0 ≦ m ≦ 1.00, and 0 ≦ n < 5.

3. The ferrimagnetic garnet film for magnetostatic wave devices according to claim 1 wherein said ferrimagnetic garnet film has a composition expressed by the general formula (I):
Y₃₋ₓMₓFe_{5-y}M'_{y}O₁₂
where M is at least one element selected from the group consisting of Bi, Gd, Lu, Sc and La, M' is at least one element selected from the group consisting of Ga and Al, x and y take a value in the respective following ranges: 0 ≦ x ≦ 1.00, and 0 ≦ y ≦ 1.00, excepting x = y = 0.

4. The ferrimagnetic garnet film for magnetostatic wave devices according to claim 1 wherein said ferrimagnetic garnet film has a composition expressed by the general formula. (II):
Y₃₋ₓMₓFe₅O₁₂
where M is at least one element selected from the group consisting of Bi, Gd, Lu, Sc and La, and 0 < x ≦ 1.00.

5. The ferrimagnetic garnet film for magnetostatic wave devices according to claim 1 wherein said ferrimagnetic garnet film has a composition expressed by the general formula (III):
Y₃Fe_{5-y}M'_{y}O₁₂
where M' is at least one element selected from the group consisting of Ga and Al, and 0 < y ≦ 1.00.

6. A ferrimagnetic garnet film for magnetostatic wave devices, comprising a modified yttrium-iron-garnet having a composition expressed by the general formula:
Y₃₋ₓMₓFe_{5-y}M'_{y}O₁₂
where M is at least one element selected from the group consisting of Bi, Gd, Lu, Sc and La, M' is at least one element selected from the group consisting of Ga and Al, x and y are mole fractions of respective elements and take a value in the respective following ranges: 0 ≦ x ≦ 1.00, and 0 ≦ y ≦ 1.00, excepting x = y = 0, said film being epitaxially grown on a nonmagnetic substrate consisting essentially of an unmodified or modified gadolinium-gallium-garnet so that the difference in lattice constant between said film and substrate is not more than 0.001 Å, said unmodified or modified gadolinium-gallium-garnet having a composition expressed by the general formula:
Gd₃₋ₘRₘGa₅₋ₙAlₙO₁₂
where R is at least one rare earth element other than Gd, 0 ≦ m ≦ 1.00, and 0 ≦ n < 5.
